# EUROPEAN PATENT APPLICATION

(11) **EP 2 960 670 A1**
(43) Date of publication of application: **30.12.2015**
(21) Application number: 15172881.3
(22) Date of filing: 19.06.2015
(51) Int. Cl.: G01R 33/28, G01N 24/00, G01R 33/26, G01R 33/032

(54) **GAS CELL WITH ANTI-RELAXATION COATING**

(30) Priority: 23.06.2014 JP 2014128138
(71) Applicant: Seiko Epson Corporation, Shinjuku-ku Tokyo 163-0811 (JP)
(72) Inventor: Nagasaka, Kimio, Nagano, 392-8502 (JP)
(74) Representative: Hoffmann Eitle

(57) **Abstract**

A gas cell (11) includes a cell main body having an internal space defined by inner walls, a gas of alkali metal or hydrogen sealed in the internal space, and a coating layer formed at least on part of the inner walls using a material having a long-chain molecule structure, wherein molecules more than half of molecules forming the coating layer are perpendicularly oriented with respect to the inner walls.

## Description

### BACKGROUND

### 1. Technical Field

The present invention relates to a gas cell having a coating layer on inner walls.

### 2. Related Art

Apparatuses using spin polarization of gas atoms sealed within gas cells such as magnetometers and atomic oscillators are known. In these apparatuses, there is a problem of relaxation of spin polarization when atoms within the gas cell collide with inner walls of the cell. To address the problem, technologies of coating the inner walls of the gas cell with paraffin are known (Patent Document 1 (JP-A-2013-7720), Non-patent Document 1 (E. B. Alexandrov and M. V. Balabas, "Light-induced desorption of alkali-metal atoms from paraffin coating", Physical Review A 66, 042903 (2002), and Non-patent Document 2 (N. Castagna, G. Bison, G. Di Domenico, A.Hofer, P. Knowles, C. Macchione, H. Saudan and A. Weis, "A large sample study of spin relaxation and magnetometric sensitivity of paraffin-coated Cs vapor cell", Applied Physics B 96(4), pp. 763-772 (2009)).

In Patent Document 1 and Non-patent Documents 1 and 2, a preferable structure of a coating layer for preventing relaxation of spin polarization is not mentioned.

### SUMMARY

An advantage of some aspects of the invention is to provide a preferable structure of a coating layer for preventing relaxation of spin polarization.

A gas cell according to an aspect of the invention includes a cell main body having an internal space defined by inner walls, a gas of alkali metal or hydrogen sealed in the internal space, and a coating layer formed at least on part of the inner walls using a material having a long-chain molecule structure, wherein molecules more than half of molecules forming the coating layer are perpendicularly oriented with respect to the inner walls.

According to this structure, a relaxation prevention effect for spin polarization may be improved.

In the gas cell according to the aspect of the invention, it is preferable that the coating layer includes a two-dimensional crystal film in which the perpendicularly-oriented molecules are periodically and two-dimensionally arranged.

In the gas cell according to the aspect of the invention, it is preferable that a plurality of the two-dimensional crystal films are stacked in directions perpendicular to the inner walls.

According to these configurations, reliability of the coating layer may be improved.

In the gas cell according to the aspect of the invention, it is preferable that, in the two-dimensional crystal film, one molecule is bonded to the other molecules by other chemical binding than van der Waals binding.

According to this configuration, reliability of the coating layer may be improved.

It is preferable that the coating layer is formed using hydrocarbon having unsaturated bonds.

### BRIEF DESCRIPTION OF THE DRAWINGS

The invention will be described with reference to the accompanying drawings, wherein like numbers reference like elements.
Fig. 1 is a block diagram showing a configuration of a magnetometric apparatus 1 according to one embodiment.
Fig. 2 is an appearance diagram of a gas cell array 10.
Fig. 3 is a sectional view along III-III of a gas cell 11.
Fig. 4 is a schematic diagram showing a structure of a coating layer 114.
Fig. 5 is a flowchart showing a method of manufacturing the gas cell 11.
Fig. 6A shows a state before the start of step S1.
Fig. 6B shows a state at step S2.
Fig. 6C shows a state at step S3.
Fig. 6D shows a state at step S4.
Fig. 6E shows a state at step S5.
Fig. 6F shows a state at step S6.

### DESCRIPTION OF EXEMPLARY EMBODIMENTS

### 1. Structure

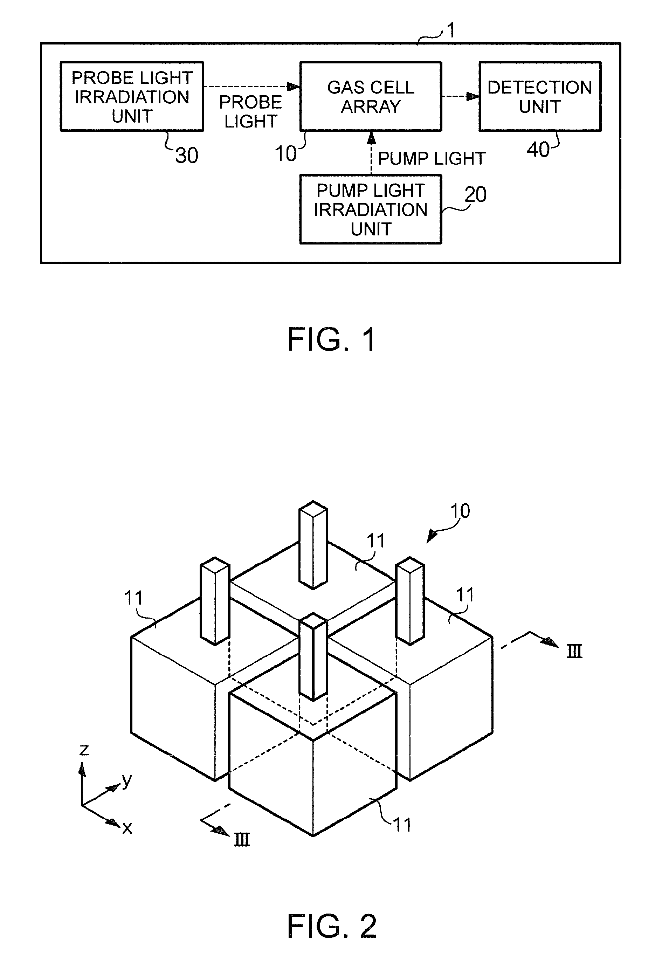

Fig. 1 is a block diagram showing a configuration of a magnetometric apparatus 1 according to one embodiment. The magnetometric apparatus 1 is a biological state measuring apparatus that measures a magnetic field generated from a living body including a magnetic field generated from a heart (cardiac magnetic field) or a magnetic field generated from a brain (cerebral magnetic field) as an index of the state of the living body. The magnetometric apparatus 1 has a gas cell array 10, a pump light irradiation unit 20, a probe light irradiation unit 30, and a detection unit 40. The gas cell array 10 has a plurality of gas cells. Within the plurality of gas cells, an alkali metal gas (e.g. cesium (Cs)) is sealed. The pump light irradiation unit 20 outputs pump light that interacts with alkali metal atoms (e.g. light having a wavelength of 894 nm corresponding to the D1 line of cesium) . The pump light has a circularly-polarized light component. When irradiated with the pump light, the outermost electrons of the alkali metal atoms are excited and spin polarization is caused. The spin-polarized alkali metal atoms precess due to a magnetic field B generated by a measured object. The spin polarization of one alkali metal atom is relaxed with time, however, the pump light is continuous wave (CW) light and formation and relaxation of spin polarization are repeated simultaneously in parallel and continuously. As a result, stationary spin polarization is formed as a whole atom cluster.

The probe light irradiation unit 30 outputs probe light having a linearly-polarized light component. Before and after transmission through the gas cell, the plane of polarization of the probe light rotates due to the Faraday effect. The rotation angle of the polarization plane is expressed as a function of the magnetic field B. The detection unit 40 detects the rotation angle of the probe light. The detection unit 40 has a photodetector that outputs a signal in response to an amount of incident light, a processor that processes the signal, and a memory that stores data. The processor calculates the magnitude of the magnetic field B using the signal output from the photodetector. The processor writes data representing the calculation result in the memory. In this manner, a user may obtain information of the magnetic field B generated by the measured object.

Fig. 2 is an appearance diagram of the gas cell array 10. In this example, the gas cell array 10 has a plurality (2 x 2) of gas cells 11 two-dimensionally arranged in a matrix along a first direction and a second direction. For explanation, an xyz orthogonal coordinate system is defined with the first direction as an x-axis positive direction and the second direction as a y-axis positive direction.

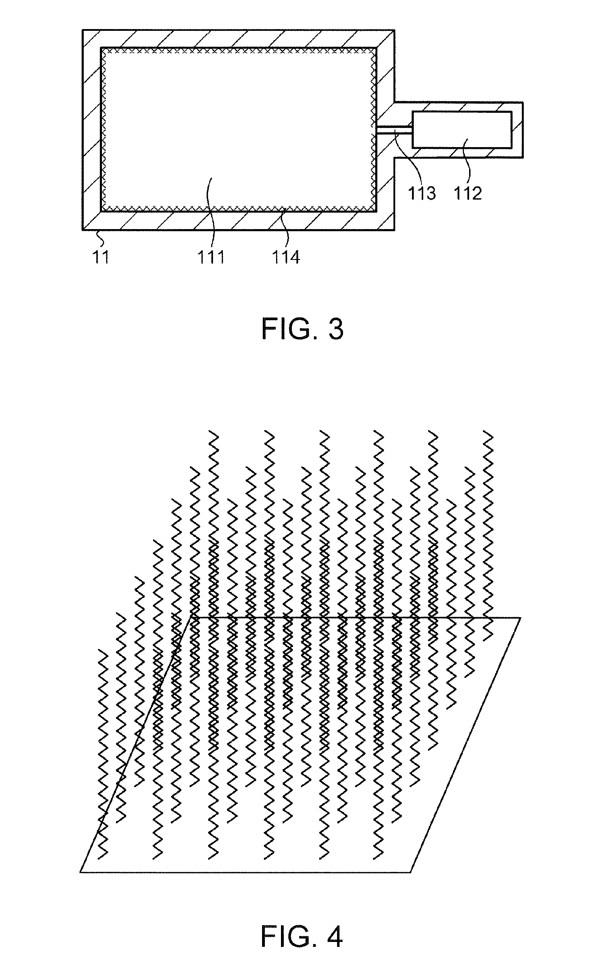

Fig. 3 is a sectional view along III-III of the gas cell 11. This section is in parallel to the yz-plane. The main body of the gas cell 11 has light transmissivity and is formed using a material that does not react with the sealed alkali metal and does not transmit the alkali metal atoms, e.g., quartz glass or borosilicate glass. The gas cell 11 has a principal chamber 111 and an auxiliary chamber 112 as internal spaces defined by inner walls of the main body. The principal chamber 111 is a space for the gas cell 11 to fulfill a function as an sensing device, i.e., a space in which the alkali metal gas is sealed. The auxiliary chamber 112 is a space that functions as an alkali metal reservoir. The alkali metal gas sealed in the principal chamber 111 is solidified at a lower temperature. In this regard, the solidified alkali metal attaches to the wall surface of the principal chamber 111, the pump light or probe light is hindered and problems are caused in the measurement. The alkali metal reservoir is a space in which the alkali metal is held for preventing the problems in the measurement. For example, a temperature difference is made between the principal chamber 111 and the auxiliary chamber 112, and thereby, the alkali metal is controlled to stay in the auxiliary chamber 112.

The principal chamber 111 and the auxiliary chamber 112 are connected by a vent hole 113. In order to make the pressure distribution within the principal chamber 111 constant, it is preferable that the diameter of the vent hole 113 is smaller. Except the part connecting to the vent hole 113 , the principal chamber 111 has a rectangular parallelepiped shape (except the vent hole 113 and the auxiliary chamber 112, the gas cell 11 has a rectangular parallelepiped shape).

The gas cell 11 has a coating layer 114 at least on part of the wall surfaces of the principal chamber 111. The coating layer 114 is provided for preventing relaxation of spin polarization. The coating layer 114 is formed using hydrocarbon having a straight-chain molecule structure, e.g., paraffin. The paraffin refers to alkane having a carbon number of 20 or more (chain saturated hydrocarbon having a general formula of CₙH₂ₙ₊₂). It is preferable that the molecular structure of paraffin has a straight chain without branching. Further, the carbon number is preferably from 40 to 60 and more preferably about 50.

Fig. 4 is a schematic diagram showing a structure of the coating layer 114. In this example, paraffin having a straight-chain molecular structure is used as the material of the coating layer 114. The states assumed by paraffin molecules include a perpendicular orientation and a parallel orientation. The perpendicular orientation refers to an orientation of paraffin molecules perpendicular to the surface (the inner wall surface of the principal chamber 111) and the parallel orientation refers to an orientation of paraffin molecules in parallel to the surface. Here, the terms of "perpendicular" and "parallel" do not only mean mathematically and strictly perpendicular and parallel but also include states with shifts from strictly perpendicular and parallel in a predetermined amount or less.

The relationship between the relaxation effect for spin polarization and the state of paraffin molecules will be explained. In an ideal crystal, polarization of paraffin molecules is the minimum and surface free energy is the minimum. Concurrently, the absorption time of the colliding atoms (staying time on the crystal surface) is the minimum. That is, the relaxation action for spin polarization is the maximum.

However, the coating layer 114 is not necessarily an ideal single-crystal film. For formation of the coating layer 114, e.g. vacuum deposition is used. In the initial stage of vacuum deposition, first, a plurality of crystal nuclei are generated on the surface, and then, crystal grains grow from the crystal nuclei as bases. That is, the paraffin film formed by vacuum deposition is a polycrystalline film. The crystal grain boundary is largely lattice-mismatched, and weak electric or magnetic polarization is generated in the paraffin molecules due to lattice mismatch. The polarization increases the surface free energy and increases the absorption time of the colliding atoms. That is, the polarization adversely affects the relaxation action for spin polarization.

Next, the orientation of paraffin molecules will be considered. In the paraffin film after vacuum deposition, generally, the molecules in the perpendicular orientation and the molecules in the parallel orientation are mixed. The lattice mismatch at the crystal grain boundary between the crystal grains in the perpendicular orientation and the crystal grains in the parallel orientation may be larger than that of the crystal grain boundary between the crystal grains in two horizontal orientations with different crystal axes, and it is considered that the reduction of the relaxation action for spin polarization is larger.

From the above described consideration, it is preferable that the coating layer 114 has the smaller crystal grain boundary between the crystal grains in the perpendicular orientation and the crystal grains in the parallel orientation. Accordingly, in the coating layer 114, the paraffin molecules are perpendicularly oriented over the nearly entire surface. In the example, the coating layer 114 is a single molecular layer formed by single paraffin molecules in the perpendicular direction, i.e., a two-dimensional crystal film.

### 2. Manufacturing Method

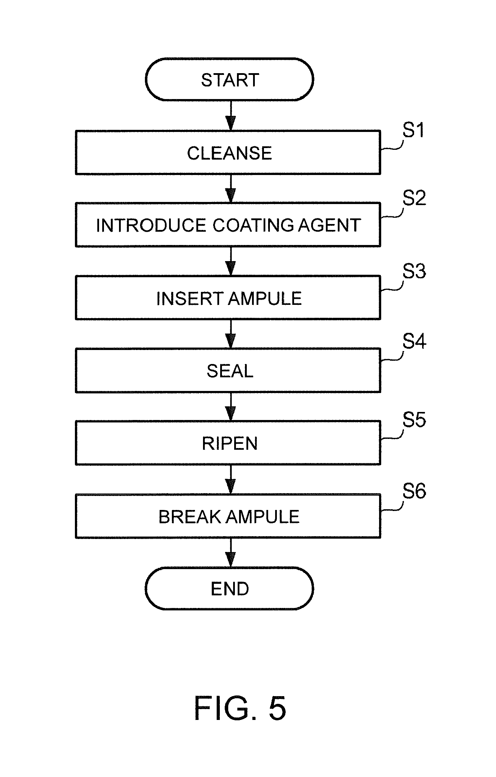

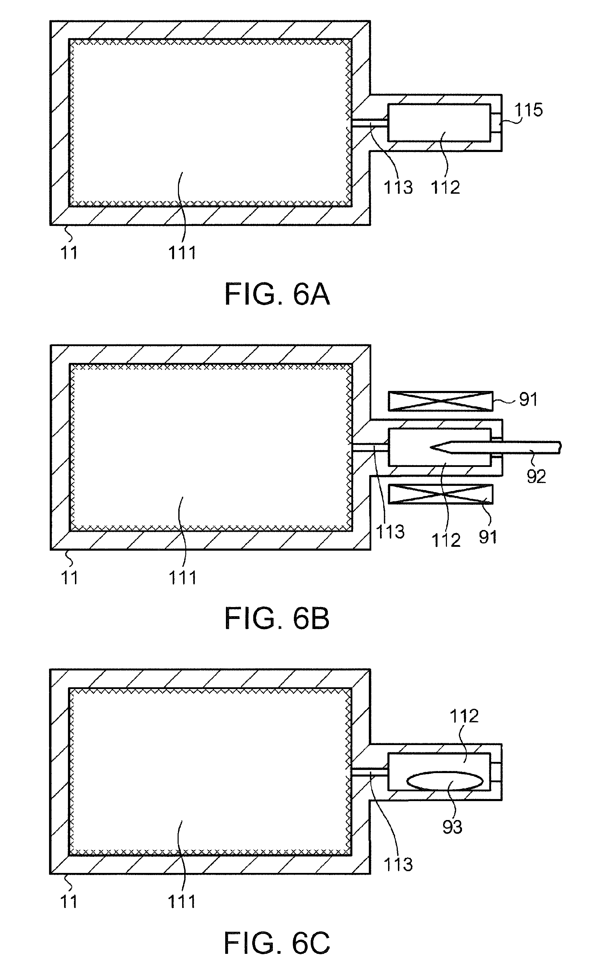

Fig. 5 is a flowchart showing a method of manufacturing the gas cell 11. Further, Figs. 6A to 6F show states of the gas cell at respective steps. Here, the explanation is started from the state in which the principal chamber 111 and the vent hole 113 are formed (Fig. 6A). At the time, the auxiliary chamber 112 is not completely formed and open to the outside air via an opening 115.

At step S1, the gas cell 11 is cleansed. For cleansing, e. g. at least one of cleansing using an acid solution or heating in a reduced-pressure atmosphere is used.

At step S2, a coating agent for formation of the coating layer 114 is introduced into the principal chamber 111. The coating agent is introduced via a needle plug 92 inserted into the opening 115 (Fig. 6B) in a reduced-pressure atmosphere. Concurrently, the auxiliary chamber 112 is heated by a heater 91. The auxiliary chamber 112 is heated, and thereby, the coating agent is absorbed and deposited on the inner walls of the principal chamber 111, not the auxiliary chamber 112.

At step S3, an ampule 93 is introduced into the auxiliary chamber 112 (Fig. 6C). Inside of the ampule 93, alkali metal atoms are encapsulated.

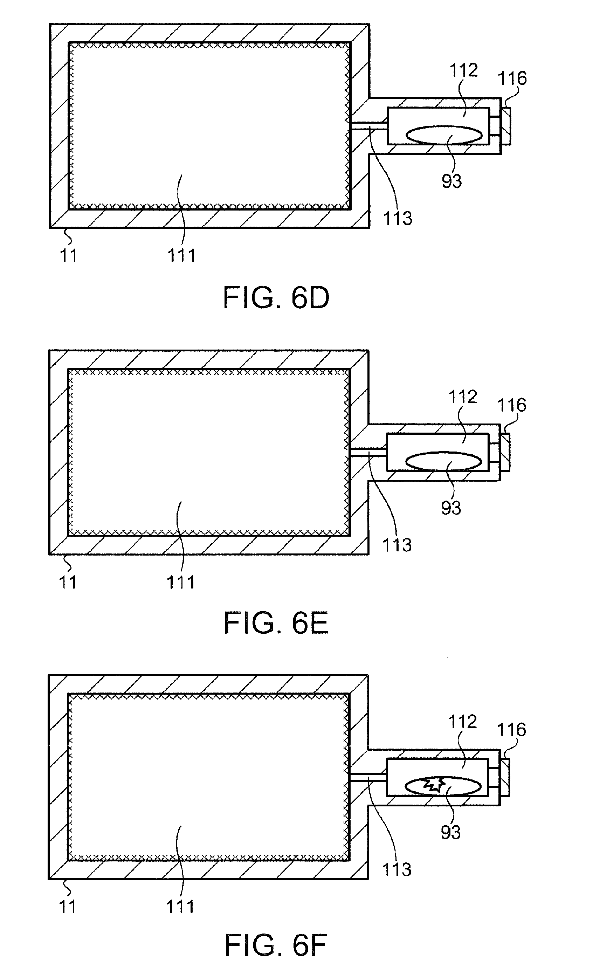

At step S4, the auxiliary chamber 112 is sealed (Fig. 6D). The auxiliary chamber 112 is sealed by closing the opening 115 with a lid 116 in a reduced-pressure atmosphere. The lid 116 is e.g. a lid formed using the same material as the gas cell 11. The lid 116 and the gas cell 11 are bonded using e.g. low-melting-point glass.

At step S5, ripening (homogenization) is performed (Fig. 6E). The ripening is heating treatment for perpendicular orientation of paraffin molecules to e.g. a temperature immediately below the melting point of paraffin. By the ripening, the paraffin molecules are desorbed from the crystal grains and repeatedly perpendicularly oriented, migrated, and recombined. By the ripening, a film close to a perpendicularly-oriented single crystal may be obtained.

At step S6, the ampule 93 is broken (Fig. 6F). When the ampule 93 is broken, the alkali metal atoms encapsulated inside are diffused and the principal chamber 111 is filled with the alkali metal. The ampule 93 is broken by applying e.g. heat by laser radiation or the like or a physical impact thereto.

Note that the steps S5 and S6 may be exchanged. That is, ripening may be performed after the ampule is broken.

### 3. Modified Examples

The invention is not limited to the above described embodiment and various modifications may be made. As below, several modified examples will be explained. Two or more of the following modified examples may be combined for use.

### 3-1. Modified Example 1

In the coating layer 114, not all of the paraffin molecules are necessarily perpendicularly oriented. For example, it is necessary that more than half of the paraffin molecules are perpendicularly oriented. Note that whether or not more than half of the paraffin molecules are perpendicularly oriented is determined using e.g. an intensity ratio between a diffraction peak corresponding to the perpendicular orientation and a diffraction peak corresponding to the parallel orientation in X-ray diffraction measurement.

### 3-2. Modified Example 2

The coating layer 114 is not limited to the single molecule layer. The coating layer 114 may have a structure in which two or more molecule layers of paraffin are stacked. With the single molecule layer, if one molecule layer is peeled, the wall surface of the cell is exposed and the relaxation effect for spin polarization is lost. However, with the two or more molecule layers, even when one molecule layer is peeled, paraffin molecules underneath may maintain the relaxation effect for spin polarization. That is, reliability of the coating layer (heat resistance, long-term reliability, etc.) may be improved.

### 3-3. Modified Example 3

The material of the coating layer 114 is not limited to those explained in the embodiment. The perpendicularly-oriented paraffin molecules are bound to the adjacent molecules by van der Waals force (van der Waals binding). However, the van der Waals force reaches a shorter range and is very weak, and thus, problems may occur in heat resistance and long-term reliability of the coating layer. Accordingly, to stabilize the structure of the coating layer 114 and improve the reliability (e.g. heat resistance and long-term reliability), a film having a structure in which adjacent molecules chemically bind may be used. The chemically binding here refers to other binding than van der Waals binding, e.g. covalent binding or ion binding. As a coating agent for formation of the film having the structure, e.g. hydrocarbon having unsaturated bonds in basic skeletons is used. In this case, the film is formed using the agent, perpendicularly oriented by ripening, and then, the unsaturated bonds are activated by ultraviolet irradiation or the like, and the basic skeletons are bonded.

Further, not only the hydrocarbon but also organic polymer such as fluorocarbon or silicone may be used as the material of the coating layer 114.

### 3-4. Modified Example 4

The shape of the gas cell 11 is not limited to that explained in the embodiment. The outer shape of the gas cell 11 may be another shape such as a spherical shape or a conical shape than the quadrate shape. The inner shape of the gas cell 11, i.e. , the shape of the principal chamber 111 may be another shape such as a spherical shape or a conical shape than the quadrate shape. Further, the gas cell 11 may not have the auxiliary chamber 112 and the vent hole 113, but have the principal chamber 111 only.

### 3-5. Modified Example 5

The atoms sealed in the gas cell 11 are not limited to the alkali metal atoms. For example, hydrogen atoms may be sealed.

The application of the gas cell 11 is not limited to the magnetometric apparatus. The gas cell 11 may be used for other apparatuses such as an atomic oscillator than the magnetometric apparatus.

The invention may be widely applied in a range without departing the scope of the invention.

## Claims

1. A gas cell comprising:
a cell main body having an internal space defined by inner walls;
a gas of alkali metal or hydrogen sealed in the internal space; and
a coating layer formed at least on part of the inner walls using a material having a long-chain molecule structure,
wherein molecules more than half of molecules forming the coating layer are perpendicularly oriented with respect to the inner walls.

2. The gas cell according to claim 1, wherein the coating layer includes a two-dimensional crystal film in which the perpendicularly-oriented molecules are periodically and two-dimensionally arranged.

3. The gas cell according to claim 2, wherein a plurality of the two-dimensional crystal films are stacked in directions perpendicular to the inner walls.

4. The gas cell according to claim 2 or 3, wherein, in the two-dimensional crystal film, one molecule is bonded to the other molecules by other chemical binding than van der Waals binding.

5. The gas cell according to any one of the preceding claims, wherein the coating layer is formed using hydrocarbon having unsaturated bonds.
